# EUROPEAN PATENT APPLICATION

(11) **EP 2 743 980 A2**
(43) Date of publication of application: **18.06.2014**
(21) Application number: 13196705.1
(22) Date of filing: 11.12.2013
(51) Int. Cl.: H01L 23/498

(54) **Lead structure**

(30) Priority: 12.12.2012 TW 101146952
(71) Applicant: Wintek Corporation, 42760 Taichung City (TW)
(72) Inventor: Chu, Kuan-Yu, 407 Taichung City (TW); Huang, Chen-Fu, 427 Taichung City (TW); Liu, Chiu-Mei, 406 Taichung City (TW); Chen, Ming-Wu, 557 Nantou County (TW); Hwang, Chin-Pei, 402 Taichung City (TW); Huang, Chun-Cheng, 630 Yunlin County (TW); Wang, Yu-Ching, 438 Taichung City (TW); Li, Chung-Hsien, 403 Taichung City (TW); Chen, Kuo-Hsing, 241 New Taipei City (TW); Chen, Yu-Ting, 324 Taoyuan County (TW); Su, Chen-Hao, 403 Taichung City (TW)
(74) Representative: Chew, Kwan Chong Daniel

(57) **Abstract**

A lead structure disposed on a substrate is provided. The substrate includes a display area disposed with a device and a peripheral area disposed with a lead structure including first pads, a second pad, first traces and a second trace. The first traces are connected to the device. Each first trace has a first linear portion and a first bonding portion connected together. Each first trace is electrically connected to one of the first pads through the first bonding portion. The second trace has a second linear portion and a second bonding portion connected together. The second trace is electrically connected to the second pad through the second bonding portion. A width of the first linear portion is smaller than a width of the first bonding portion, and a width of the second linear portion is smaller than a width of the second bonding portion.

## Description

### CROSS-REFERENCE TO RELATED APPLICATION

This application claims the priority benefit of Taiwan application serial no. 101146952, filed on December 12, 2012. The entirety of the above-mentioned patent application is hereby incorporated by reference herein and made a part of this specification.

### BACKGROUND

### Field of the Invention

The invention relates to a lead structure, and more particularly, to a lead structure improving electrostatic discharge (ESD) protection.

### Description of Related Art

An electrostatic discharge (ESD) phenomenon is quite common in our daily life. Generally speaking, electronic products would likely be damaged by the ESD during manufacturing, packaging, testing, transportation, or even the final assembly and use and thus fail to operate normally. Therefore, the electronic products have to be equipped with an ESD protection design, so that the serving life of the electronic products can be effectively prolonged.

Most of the current techniques dispose an ESD protection circuit around an electronic device to prevent from the damage caused by the ESD phenomenon, and a common ESD protection circuit is a grounded circuit structure. In current integrated circuits, display panels or touch panels, a peripheral area is disposed with a metal trace and a metal-oxide pad bonded to the metal trace which electrically connected to an electronic device to a drive chip or a flexible circuit board. The disposition of the metal trace helps to improve the conductivity of the peripheral circuit, and the bonding of the metal-oxide pad to the metal trace helps to prevent the metal trace from oxidation. However, since the trace and the pad have different resistances, when sudden currents excessively accumulate on a connection portion of the trace and the pad, the peripheral circuit structure is damaged by the ESD. In particular, the connection portion of the grounded pad that serves as an ESD protection circuit and the corresponding trace is more likely to be damaged by the ESD. Therefore, the connection portion of the trace and the pad (such as a grounded pad) requires a further design to improve the ESD protection ability of the peripheral circuit structure, thereby improving the reliability of integrated circuits, display panels or touch panels.

### SUMMARY OF THE INVENTION

The invention provides a lead structure, in which a connection portion of traces and pads improves an electrostatic discharge (ESD) protection design.

The invention provides a lead structure disposed on a substrate. The substrate includes a display area and a peripheral area located around the display area, wherein the lead structure is disposed in the peripheral area, and the display area is disposed with at least one device. The lead structure includes a plurality of first pads, at least one second pad, a plurality of first traces and at least one second trace. The first traces are connected to the device in the display area. Each of the first traces has a first bonding portion and a first linear portion connected to the first bonding portion. Each of the first traces is electrically connected to one of the first pads through the first bonding portion. The second trace has at least one second bonding portion and a second linear portion connected to the second bonding portion. The second trace is electrically connected to the second pad through the second bonding portion, wherein a width of the first linear portion is smaller than a width of the first bonding portion, and a width of the second linear portion is smaller than a width of the second bonding portion.

In an embodiment of the invention, a resistance of each of the first traces is smaller than a resistance of each of the first pads, and a resistance of the second trace is smaller than a resistance of the second pad.

In an embodiment of the invention, the first traces and the second trace are made of metals or metal alloys, and the first pads and the second pad are made of metal oxides.

In an embodiment of the invention, each of the first pads has a first width, the second pad has a second width, and a second width is greater than a first width.

In an embodiment of the invention, the width of the second linear portion is substantially the same as the width of each of the first linear portions.

In an embodiment of the invention, a first distance is formed between two of the adjacent first pads, and a second distance is formed between the second pad and an adjacent first pad, wherein the first distance is substantially the same as the second distance.

In an embodiment of the invention, a number of the second pad is plural, and the second pads are disposed adjacent to one another or interposed among the first pads.

In an embodiment of the invention, at least one of the second pads disposed adjacent to one another is electrically connected to the device.

In an embodiment of the invention, the second pads are connected to a ground potential.

In an embodiment of the invention, a number of the second pad is two, and the first pads are located between the two second pads. The two second pads are connected to the same second trace, the second trace has two second bonding portions, and each of the second bonding portions is respectively electrically connected to one of the second pads. The second trace is disposed around the display area, and a distance between the second trace and an edge of the substrate is smaller than a distance between the first traces and the edge of the substrate.

In an embodiment of the invention, the first width is greater than the width of the first bonding portion, and the second width is greater than the width of the second bonding portion.

In an embodiment of the invention, the first bonding portion of each of the first traces is located between the substrate and one of the first pads, and the second bonding portion of the second trace is located between the substrate and the second pad.

In an embodiment of the invention, a length of the second bonding portion is equal to a length of the second pad.

In an embodiment of the invention, a length of the first bonding portions is equal to a length of the first pad.

In an embodiment of the invention, a portion of the second pad is located between the substrate and the second bonding portion of the second trace, and the second bonding portion extends from a top surface of a portion of the second pad to a sidewall of a portion of the second pad.

In an embodiment of the invention, a portion of each of the first pads is located between the substrate and one of the first bonding portions, and the first bonding portion extends from a top surface of the portion of the first pad to a sidewall of the portion of the first pad.

In an embodiment of the invention, the device disposed in the display area is a touch device or a display device.

Based on the above, when the materials of the pads and the traces have different resistances, the invention improves the flow capacity of currents at a connection portion of the second pad connected to the corresponding traces by increasing the width of the connection portion (such as the bonding portions) of the traces connected to the pads, so as to prevent sudden currents from accumulating in the connection portion, so that the lead structure may not be damaged by the ESD. In this way, the lead structure has good ESD protection ability and improves the reliability of integrated circuits, display panels or touch panels using the lead structure.

In order to make the aforementioned features and advantages of the invention more comprehensible, embodiments accompanied with figures are described in detail below.

### BRIEF DESCRIPTION OF THE DRAWINGS

The accompanying drawings are included to provide further understanding and are incorporated in and constitute a part of this specification. The drawings illustrate exemplary embodiments and, together with the description, serve to explain the principles of the invention.
Fig. 1 is a schematic top view of a touch panel using a lead structure according to an embodiment of the invention.
Fig. 2 is an enlarged schematic view of an area depicted in Fig. 1.
Figs. 3 to 5 are partial schematic views of lead structures according to other embodiments of the invention.
Fig. 6A is a partial schematic view of a lead structure according to an embodiment of the invention.
Fig. 6B is a schematic cross-sectional view taken along line I-I and line II-II in Fig. 6A.
Fig. 7A is a partial schematic view of a lead structure according to another embodiment of the invention.
Fig. 7B is a partial schematic side view of Fig. 7A.

### DESCRIPTION OF EMBODIMENTS

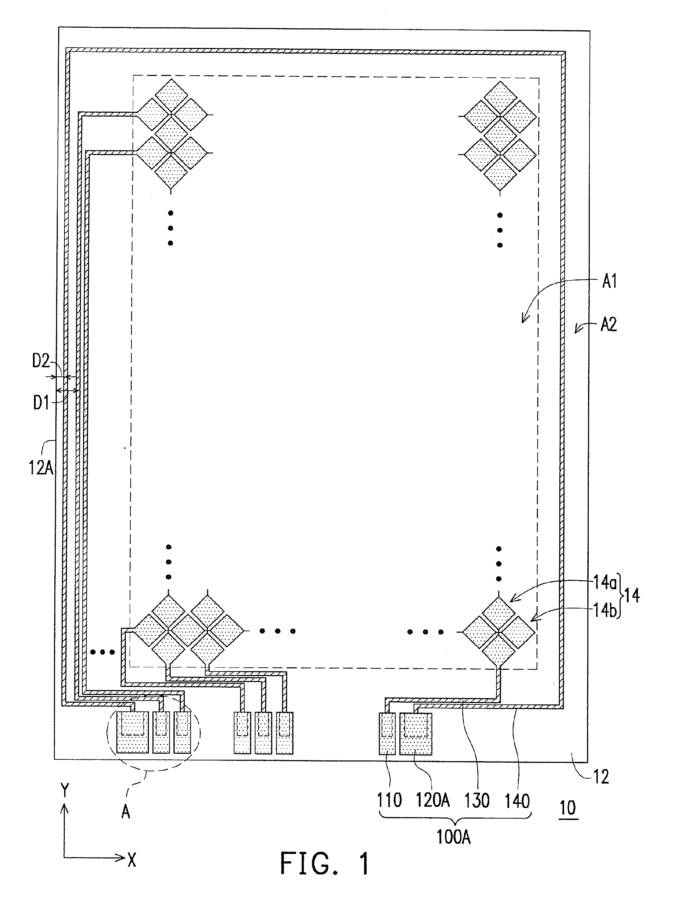

Fig. 1 is a schematic top view of a touch panel using a lead structure according to an embodiment of the invention. Referring to Fig. 1, a lead structure 100A of the present embodiment may be applied in a touch panel 10, for example, wherein the touch panel 10 includes a substrate 12, and the lead structure 100A of the present embodiment is disposed on the substrate 12.

In detail, the substrate 12 includes a display area Al and a peripheral area A2 located around the display area A1, wherein the lead structure 100A is disposed in the peripheral area A2, and the display area Al corresponds to at least one device 14. The images from the display are shown within the display area Al through the light transmissive substrate 12.

In the present embodiment, the device 14 is, for example, a touch device, and a plurality of touch devices are arranged in the display area Al in an array. For example, the device 14 as a touch device may include a first sensing series 14a and a second sensing series 14b, wherein the first sensing series 14a is arranged along a second direction Y, and the second sensing series 14b is arranged along a first direction X. In the present embodiment, the first direction X is perpendicular to the second direction Y, for example. Indeed, the above implementation only serves as an example and is not used to limit the invention.

In other embodiments that are not illustrated, the first direction X may not be perpendicular to the second direction Y. Alternatively, the device 14 may be a touch device in other forms, like one layer solution structure, wherein the touch device can be patterned in the form of meshes. When the lead structure 100A is used in a display panel, the device 14 may be a thin film transistor array that drives a display medium or a display device array, such as an organic light emitting units array. In general, all components disposed on the substrate 12 to provide specific functions like light emission, image displaying, touch sensing, light sensing, etc. can be the examples of the device 14.

The lead structure 100A includes a plurality of first pads 110, at least one second pad 120A, a plurality of first traces 130 and at least one second trace 140. The following is an example in which there are two second pads 120A and one second trace 140 described for illustration, but the invention is not limited thereto.

In detail, the first pads 110 and the second pads 120A are electrically insulated from one another and are arranged along the first direction X; however, the present embodiment does not specifically limit the arrangement of the pads. In addition, the first pads 110 of the present embodiment are located between the two second pads 120A.

An end of each of the first traces 130 is electrically connected to one of the first pads 110. The electrical connection method may include making the first traces 130 partially overlap and contact the first pads 110. In addition, another end of each of the first traces 130 can be connected to the device 14 in the display area A1. When the device 14 is a touch device in a series form, the first traces 130 may be connected to an end portion of the first sensing series 14a and an end portion of the second sensing series 14b.

Two ends of the second trace 140 are respectively electrically connected to one of the second pads 120A; in other words, the two second pads 120A are connected to the same second trace 140. In addition, the second trace 140 of the present embodiment is disposed around the display area A1, and a distance D2 between the second trace 140 and an edge 12A of the substrate 12 is smaller than a distance D1 between any of the first traces 130 and the edge 12A of the substrate 12. Furthermore, by connecting the second pads 120A to a ground potential, the second trace 140 of the present embodiment may serve as an ESD protection circuit to prevent from the damage caused by the ESD phenomenon.

In the present embodiment, a resistance of each of the first traces 130 is smaller than a resistance of each of the first pads 110, and a resistance of the second trace 140 is smaller than a resistance of the second pads 120A. Moreover, materials of the first traces 130 and the second trace 140 are, for example, metals, metal composite or metal alloys, and materials of the first pads 110 and the second pads 120A are, for example, metal oxides. In an embodiment, in order for the display area Al to have light transmissive characteristics, the materials of the first sensing series 14a and the second sensing series 14b of the touch device are made of transparent conductive material. The first pads 110 and the second pads 120A may be manufactured at the same process as the first sensing series 14a and the second sensing series 14b. However, the invention is not limited to the above.

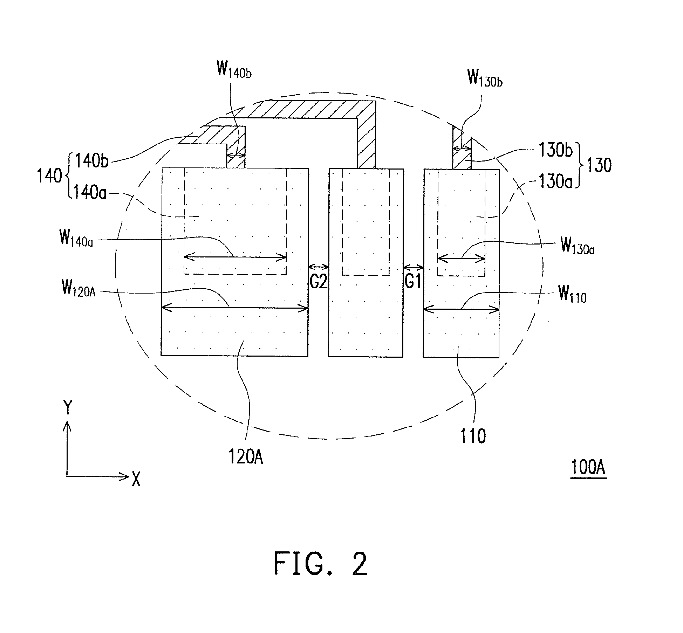

Fig. 2 is an enlarged schematic view of an area A depicted in Fig. 1. Referring to Fig. 2, each of the first traces 130 has a first bonding portion 130a and a first linear portion 130b connected to the first bonding portion 130a, wherein each of the first traces 130 is electrically connected to one of the first pads 110 through the first bonding portion 130a. The second trace 140 has at least one second bonding portion 140a and a second linear portion 140b connected to the second bonding portion 140a, wherein the second trace 140 is electrically connected to the second pads 120A through the second bonding portion 140a. Specifically, the second trace 140 of the present embodiment has two bonding portions 140a so as to be electrically connected to the two second pads 120A, respectively.

In the present embodiment, a width W_{130b} of the first linear portions 130b is smaller than a width W₁₃₀ₐ of the first bonding portions 130a, and a width W_{140b} of the second linear portion 140b is smaller than a width W₁₄₀ₐ of the second bonding portions 140a, wherein the width W_{140b} of the second linear portion 140b is substantially the same as the W_{130b} of the first linear portions 130b. In addition, a first width W₁₁₀ of the first pads 110 is greater than the width W₁₃₀ₐ of the first bonding portions 130a, and a second width W_{120A} of the second pads 120A is greater than the width W₁₄₀ₐ of the second bonding portions 140a. Furthermore, a first distance G1 is formed between adjacent two of the first pads 110, and a second distance G2 is formed between each of the second pads 120A and an adjacent first pad 110, wherein the first distance G1 is substantially the same as the second distance G2.

It should be noted that a width of a connection portion of each of the second pads 120A and the second bonding portions 140a (the second trace 140) is increased in the present embodiment by increasing the second width W_{120A} of the second pads 120A and the width W₁₄₀ₐ of the second bonding portions 140a. In this way, the present embodiment improves the flow capacity of currents in the connection portion (which refers to the portion of the second trace 140 in contact with the second pad 120A) liable to be damaged by the ESD and prevents sudden currents from accumulating in the connection portion, so that the lead structure 100A may not be damaged by the ESD. Therefore, the lead structure 100A of the present embodiment has good ESD protection ability and improves the reliability of integrated circuits, display panels or touch panels using the lead structure 100A.

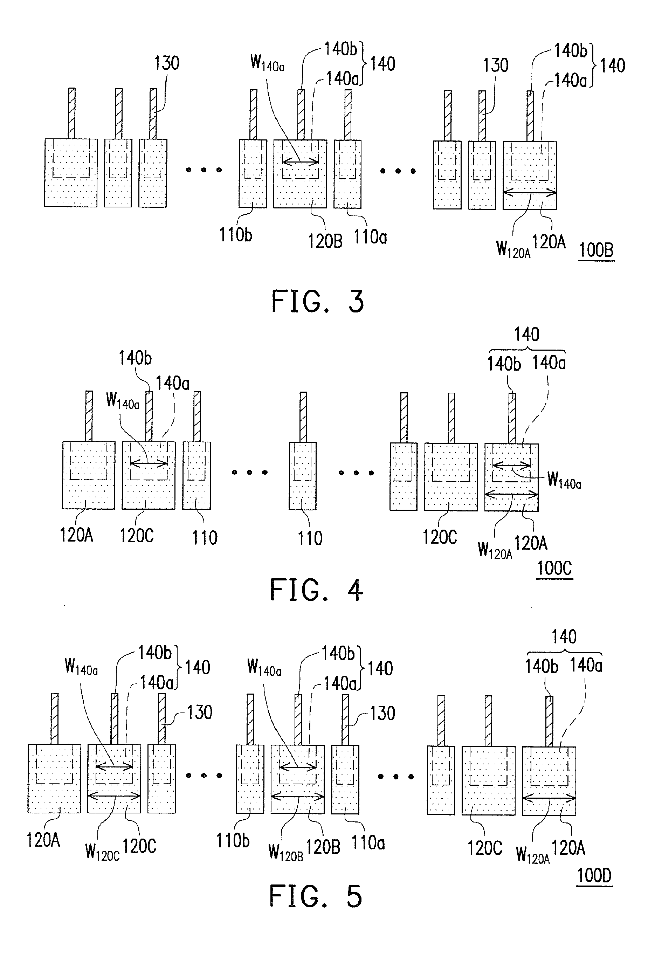

In addition, in embodiments of Figs. 3 to 5, one of the second pads 120B interposed among the first pads 110 and another of the second pads 120C adjacent to the second pads 120A may be further included.

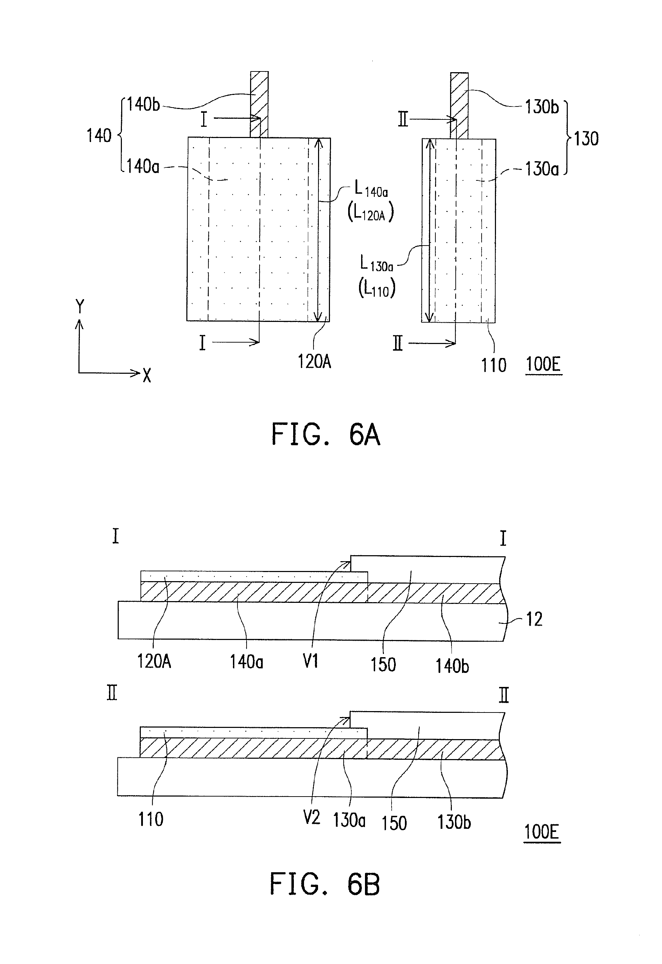

The lead structures 100A, 100B, 100C and 100D improve the ESD protection ability by increasing the widths of the second pads 120A, 120B, 120C and 120D and the widths of the second bonding portions 140a bonded to the second pads 120A, 120B, 120C and 120D along the first direction X. Figs. 6A and 6B illustrate other implementations to improve the ESD protection ability in the following.

Fig. 6A is a partial schematic view of a lead structure according to an embodiment of the invention, and Fig. 6B is a schematic cross-sectional view taken along line I-I and line II-II in Fig. 6A. To facilitate illustration, Figs. 6A and 6B illustrate only one first pad 110, one second pad 120A, one first trace 130 and one second trace 140.

Referring to Figs. 6A and 6B, a lead structure 100E of the present embodiment is similar to the lead structure 100A of the embodiment of Fig. 2. To be more specific, the first pad 110 covers the first bonding portion 130a of the first trace 130 completely, and the second pad 120A covers the second bonding portion 140a of the second trace 140 completely. Furthermore, the lead structure 100E may include an insulation layer 150 that covers the linear portions 130b and 140b of the traces 130 and 140, wherein the insulation layer 150 includes a first via V1 that exposes the first pad 110 and a second via V2 that exposes the second pad 120A.

The major differences between the lead structure 100E of the present embodiment and the lead structure 100A of the embodiment of Fig. 2 lie in that an extending length L₁₄₀ₐ of the second bonding portion 140a along the second direction Y (i.e. an extension direction of each of the first trace 130 and the second trace 140) is equal to an extending length L_{120A} of the second pad 120A, and that an extending length L₁₃₀ₐ of the first bonding portion 130a along the second direction Y is equal to an extending length L₁₁₀ of the first pad 110.

In other words, in addition to increasing the width of the contact area of the second bonding portion 140a and the second pad 120A along the first direction X, the present embodiment further increases the extending length L₁₃₀ₐ of the first bonding portion 130a and the extending length L₁₄₀ₐ of the second bonding portion 140a so as to improve the flow capacity of the currents in the connection portion liable to be damaged by the ESD and to prevent sudden currents from accumulating in the connection portion, so that the lead structure 100E may not be damaged by the ESD. Therefore, the lead structure 100E of the present embodiment has good ESD protection ability and improves the reliability of integrated circuits, display panels or touch panels using the lead structure 100E.

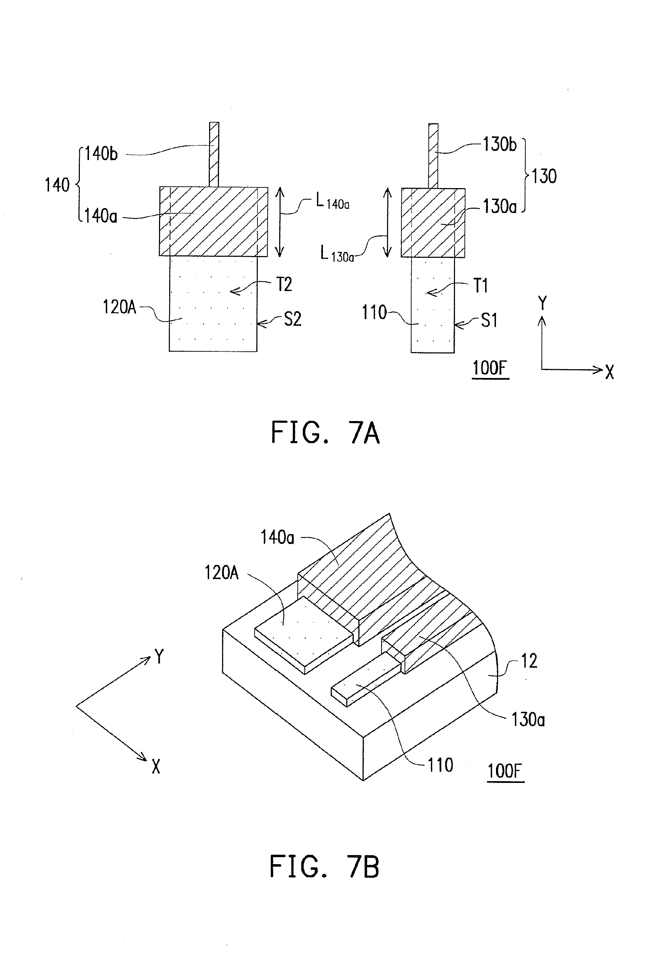

The above embodiments use a structure in which the pads cover the traces as an example for illustration, but the invention is not limited thereto. Figs. 7A and 7B illustrate other implementations of lead structures in the following.

Fig. 7A is a partial schematic view of a lead structure according to another embodiment of the invention. Fig. 7B is a partial schematic side view of Fig. 7A. Referring to Fig. 7A, a lead structure 100F of the present embodiment is similar to the lead structure 100A of Fig. 2. The major differences between the two embodiments lie in that the first bonding portion 130a of the first trace 130 is located above the first pad 110, and the second bonding portion 140a of the second trace 140 is located above the second pad 120A, wherein the first bonding portion 130a extends from a top surface T of the first pad 110 to a sidewall S of the first pad 110, and the second bonding portion 140a extends from a top surface T of the second pad 120A to a sidewall S of the second pad 120A.

In summary of the above, the embodiments of the invention improve the flow capacity of the currents by increasing an area of the connection portion of the traces in contact with the pads (such as by increasing the widths or lengths of the bonding portions of the traces or by rendering the bonding portions covering the pads) so as to prevent sudden currents from accumulating in the connection portion, so that the lead structure may not be damaged by the ESD. In this way, the lead structure has good ESD protection ability and improves the reliability of integrated circuits, display panels or touch panels using the lead structure.

Although the invention has been described with reference to the above embodiments, they are not intended to limit the invention. It is apparent to people of ordinary skill in the art that modifications and variations to the invention may be made without departing from the spirit and scope of the invention. In view of the foregoing, the protection scope of the invention will be defined by the appended claims.

## Claims

1. A lead structure (100A, 100B, 100C, 100D, 100E, 100F) disposed on a substrate (12), the substrate (12) comprising a display area (A1) and a peripheral area (A2) located around the display area (A1), wherein the lead structure (100A, 100B, 100C, 100D, 100E, 100F) is disposed in the peripheral area (A2), and the display area (A1) corresponds to at least one device (14), and the lead structure (100A, 100B, 100C, 100D, 100E, 100F) comprising:
a plurality of first pads (110, 110a, 110b);
at least one second pad (120A, 120B, 120C);
a plurality of first traces (130) connected to the device (14) in the display area (A1), wherein each of the first traces (130) has a first bonding portion (130a) and a first linear portion (130b) connected to the first bonding portion (130a), and each of the first traces (130) is electrically connected to one of the first pads (110, 110a, 110b) through the first bonding portion (130a); and
at least one second trace (140) having at least one second bonding portion (140a) and a second linear portion (140b) connected to the second bonding portion (140a), the second trace (140) being electrically connected to the second pad (120A, 120B, 120C) through the second bonding portion (140a), wherein a width (W_{130b}) of the first linear portion (130b) is smaller than a width (W₁₃₀ₐ) of the first bonding portion (130a), and a width (W_{140b}) of the second linear portion (140b) is smaller than a width (W₁₄₀ₐ) of the second bonding portion (140a).

2. The lead structure (100A, 100B, 100C, 100D, 100E, 100F) according to claim 1, wherein a resistance of each of the first traces (130) is smaller than a resistance of each of the first pads (110, 110a, 110b), and a resistance of the second trace (140) is smaller than a resistance of the second pad (120A, 120B, 120C).

3. The lead structure (100A, 100B, 100C, 100D, 100E, 100F) according to claim 2, wherein the first traces (130) and the second trace (140) are made of metals or metal alloys, and the first pads (110, 110a, 110b) and the second pad (120A, 120B, 120C) are made of metal oxides.

4. The lead structure (100A, 100B, 100C, 100D, 100E, 100F) according to claim 1, wherein each of the first pads (110, 110a, 110b) has a first width (W₁₁₀), the second pad (120A, 120B, 120C) has a second width (W_{120A}, W_{120B}, W_{120C}), and the second width (W_{120A}, W_{120B}, W_{120C}) is greater than the first width (W₁₁₀).

5. The lead structure (100A, 100B, 100C, 100D, 100E, 100F) according to claim 4, wherein the width (W_{140b}) of the second linear portion (140b) is substantially the same as the width (W_{130b}) of each of the first linear portions (130b).

6. The lead structure (100A, 100B, 100C, 100D, 100E, 100F) according to claim 1, wherein a first distance (G1) is formed between two of the adjacent first pads (110, 110a, 110b), a second distance (G2) is formed between the second pad (120A, 120B, 120C) and an adjacent first pad (110, 110a, 110b), and the first distance (G1) is substantially the same as the second distance (G2).

7. The lead structure (100A, 100B, 100C, 100D, 100E, 100F) according to claim 1, wherein the number of the second pad (120A, 120B, 120C) is plural, and the second pads (120A, 120B, 120C) are disposed adjacent to one another or at least one second pad (120A, 120B, 120C) is interposed among the first pads (110, 110a, 110b).

8. The lead structure (100A, 100B, 100C, 100D, 100E, 100F) according to claim 7, wherein at least one of the second pads (120A, 120B, 120C) disposed adjacent to one another is electrically connected to the device (14).

9. The lead structure (100A, 100B, 100C, 100D, 100E, 100F) according to claim 1, wherein the second pad (120A, 120B, 120C) is connected to a ground potential.

10. The lead structure (100A, 100B, 100C, 100D, 100E, 100F) according to claim 9, wherein the number of the second pad (120A, 120B, 120C) is two, the first pads (110, 110a, 110b) are located between the two second pads (120A, 120B, 120C), the two second pads (120A, 120B, 120C) are connected to the same second trace (140), the second trace (140) has two second bonding portions (140a), each of the second bonding portions (140a) is respectively electrically connected to one of the second pads (120A, 120B, 120C), the second trace (140) is disposed around the display area (A1), and a distance (D2) between the second trace (140) and an edge of the substrate (12) is smaller than a distance (D1) between the first traces (130) and the edge of the substrate (12).

11. The lead structure (100A, 100B, 100C, 100D, 100E, 100F) according to claim 1, wherein each of the first pads (110, 110a, 110b) has a first width (W₁₁₀), the second pad (120A, 120B, 120C) has a second width (W_{120A}, W_{120B}, W_{120C}), the first width (W₁₁₀) is greater than the width (W₁₃₀ₐ) of the first bonding portion (130a), and the second width (W_{120A}, W_{120B}, W_{120C}) is greater than the width (W₁₄₀ₐ) of the second bonding portion (140a).

12. The lead structure (100A, 100B, 100C, 100D, 100E, 100F) according to claim 11, wherein the first bonding portion (130a) of each of the first traces (130) is located between the substrate (12) and one of the first pads (110, 110a, 110b), and the second bonding portion (140a) of the second trace (140) is located between the substrate (12) and the second pad (120A, 120B, 120C).

13. The lead structure (100A, 100B, 100C, 100D, 100E, 100F) according to claim 12, wherein a length of the second bonding portion (140a) is equal to a length of the second pad (120A, 120B, 120C).

14. The lead structure (100A, 100B, 100C, 100D, 100E, 100F) according to claim 12, wherein a length (L₁₃₀ₐ) of the first bonding portions (130a) is equal to a length (L₁₁₀) of the first pad (110, 110a, 110b).

15. The lead structure (100A, 100B, 100C, 100D, 100E, 100F) according to claim 1, wherein a portion of the second pad (120A, 120B, 120C) is located between the substrate (12) and the second bonding portion (140a), and the second bonding portion (140a) extends from a top surface (T) of a portion of the second pad (120A, 120B, 120C) to a sidewall (S) of a portion of the second pad (120A, 120B, 120C).

16. The lead structure (100A, 100B, 100C, 100D, 100E, 100F) according to claim 1, wherein a portion of each of the first pads (110, 110a, 110b) is located between the substrate (12) and one of the first bonding portions (130a), and the first bonding portion (130a) extends from a top surface (T) of the portion of the first pad (110, 110a, 110b) to a sidewall (S) of the portion of the first pad (110, 110a, 110b).
